# EUROPÄISCHE PATENTSCHRIFT

(11) **EP 0 991 303 B1**
(45) Veröffentlichungstag und Bekanntmachung des Hinweises auf die Patenterteilung: **20.11.2002**
(21) Anmeldenummer: 99116791.7
(22) Anmeldetag: 31.08.1999
(51) Int. Cl.: H05B 33/00, H05B 33/26, C08G 61/12, C08G 61/02, H01B 1/12, H05B 33/14

(54) **Hilfsschichten für elektrolumineszierende Anordnungen**
Auxiliary layers for electroluminescent devices
Couches auxiliaires pour des dispositifs électroluminescents

(30) Priorität: 12.09.1998 DE 19841803
(43) Veröffentlichungstag der Anmeldung: 05.04.2000
(73) Patentinhaber: Bayer Aktiengesellschaft, 51368 Leverkusen (DE)
(72) Erfinder: Jonas, Friedrich, Dr., 52066 Aachen (DE); Wehrmann, Rolf, Dr., 47800 Krefeld (DE); Elschner, Andreas, Dr., 45479 Mülheim (DE); Heuer, Helmut-Werner, Dr., 47829 Krefeld (DE)

(56) Entgegenhaltungen:
- EP-A- 0 686 662
- DE-A- 19 627 071
- US-A- 5 719 467
- Synthetic Metals, 87, 171(1997). XP002127849
- Advanced Materials, 7, 788(1995). XP000520462
- Nature, 357,477(1992). XP002127850
- Synthetic Metals, 82, 221(1996). XP002127851

## Beschreibung

Die Erfindung betrifft elektrolumineszierende Anordnungen, die leitfähige Polymere als Hilfsschichten enthalten.

Eine elektrolumineszierende (EL) Anordnung ist dadurch charakterisiert, daß sie unter Anlegung einer elektrischen Spannung unter Stromfluß Licht aussendet Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht kombinieren.

Die in der Technik gebräuchlichen LEDs bestehen zum überwiegenden Teil aus anorganischen Halbleitermaterialien. Seit einigen Jahren sind jedoch EL-Anordnungen bekannt, deren wesentliche Bestandteile organische Materialien sind.

Diese organischen EL-Anordnungen enthalten in der Regel eine oder mehrere Schichten aus organischen Ladungstransportverbindungen.

Der prinzipielle Schichtaufbau ist wie folgt. Die Zahlen 1 bis 10 bedeuten dabei:
- 1: Träger, Substrat
- 2: Basiselektrode
- 3: Löcher-injizierende Schicht
- 4: Löcher-transportierende Schicht
- 5: Emitter-Schicht
- 6: Elektronen-transportierende Schicht
- 7: Elektronen-injizierende Schicht
- 8: Topelektrode
- 9: Kontakte
- 10: Umhüllung, Verkapselung

Dieser Aufbau stellt den allgemeinsten Fall dar und kann vereinfacht werden, indem einzelne Schichten weggelassen werden, wobei eine der verbleibenden Schichten mehrere Aufgaben übernehmen. Im einfachsten Fall besteht eine EL-Anordnung aus zwei Elektroden, zwischen denen sich eine organische Schicht befindet, die alle Funktionen, inklusive der der Emission von Licht, erfüllt. Derartige Systeme sind beispielsweise in der Patentanmeldung WO-A 90/13148 auf der Basis von Poly[pphenylenvinylen] beschrieben.

Bei der Herstellung von großflächigen, elektrolumineszierenden Anzeigeelementen muß mindestens eine der stromzuführenden Elektroden 2 oder 8 aus einem transparenten und leitfähigem Material bestehen.

Als Substrat 1 sind transparente Träger wie Glas oder Folien aus Kunststoff wie Polyester, beispielsweise Polyethylenterephthalat oder Polyethylennaphthalat, Polycarbonat, Polyacrylat, Polysulfon, Polyimid geeignet.

Als transparente und leitfähige Materialien sind geeignet:
a) Metalloxide, beispielsweise Indium-Zinn-Oxid (ITO), Zinnoxid (NESA);
b) semi-tranparente Metallfilme, beispielsweise Au, Pt, Ag, Cu etc.,

Geeignete Emitterschichten 5 sind in DE-A 196 27 071 beschrieben. Es hat sich aber in der Praxis gezeigt, daß zur Erhöhung der Leuchtdichte elektronen- bzw. lochinjizierende Schichten (3,4 und/oder 6,7) in die elektrolumineszierenden Aufbauten eingebaut werden müssen. Aus der EP-A 686 662 ist bekannt spezielle Mischungen aus leitfähigen organischen polymeren Leitern wie 3,4-Polyethylendioxythiophen und Polyhydroxyverbindungen oder Lactamen als Elektrode 1 in ELP-Aufbauten einzusetzen. Es hat sich aber in der Praxis gezeigt, daß diese Elektroden besonders für großflächige Anzeigen eine nicht ausreichende Leitfähigkeit aufweisen.

Aus der DE-A 196 27 071 der EP 686662 und Synth. Metals, 87, 171 (1997) ist bekannt, polymere organische Leiter beispielsweise 3,4-Polyethylendioxythiophen als lochinjizierende Schichten einzusetzen. Hierdurch kann die Leuchtstärke der elektrolumineszierenden Anzeigen gegenüber Aufbauten ohne den Einsatz polymerer organischer Zwischenschichten deutlich gesteigert werden. Die Lebensdauer dieser Anzeigen ist aber für praktische Anwendungen immer noch nicht ausreichend.

Die Aufgabe der vorliegenden Erfindung bestand darin, die Lebensdauer von ELP-Aufbauten auf Basis organischer Materialien zu erhöhen.

Überraschenderweise wurde jetzt gefunden, daß durch Einsatz einer Lösung oder Dispersion von polymeren organischen Leitern mit einer sehr kleinen Partikelgröße und im Falle der Verwendung von leitfähigen Polymeren der Formel I einem speziellen Verhältnis der leitfähigen polymeren Polykationen zu nichtleitfähigen Gegenionen bzw. nicht ionischen Bindemitteln die Lebensdauer der elektrolumineszierenden Anzeigen deutlich gesteigert werden kann. Außerdem hat es sich gezeigt, daß auf diese Weise die Häufigkeit von Kurzschlüssen zwischen den beiden leitfähigen Elektroden 2 und 8 deutlich gesenkt werden kann.

Gegenstand der vorliegenden Erfindung ist eine elektrolumineszierende Anordnung, die als lochinjizierende Schicht einen polymeren organischen Leiter enthält, der entweder aus Lösung aufgebracht worden ist oder aus einer Dispersion aufgebracht worden ist, in der die Teilchen auch im gegebenenfalls gequollenem Zustand eine Größe unterhalb von 0,5 µm, insbesondere unterhalb von 0,25 µm, aufweisen.

Geeignete polymere organische Leiter sind gegebenenfalls substituierte Polyfurane, Polypyrrole, Polyaniline oder Polythiophene. Diese sind beispielsweise in der EP-A 2 257 573 (Polyalkoxythiophene), WO-A 90/04256 (Polyaniline), EP-A 0 589 529 (Polypyrrol), DE-A 22 62 743 (Oligoaniline) beschrieben. Besonders geeignete polymere organische Leiter sind neutrale oder kationische, lösliche bzw. unlösliche Alkylendioxythiophene der Formel I 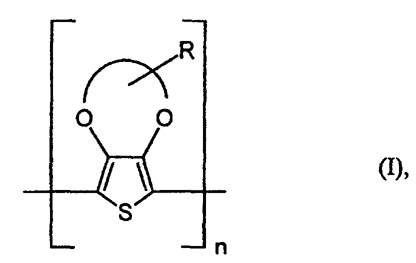 in der
- n: für eine ganze Zahl von 5 bis 100 und
- R: für H, einen gegebenenfalls substituierten Alkylrest mit 1 bis 20 C-Atomen, -CH₂-OH oder einen Arylrest mit 6 - 14 C-Atomen
steht.

Beispiele für besonders geeignete Alkylendioxythiophene sind in EP-A 440 957 und DE-A 42 11 459 beschrieben.

Ebenfalls besonders geeignet sind neutrale oder kationische lösliche oder unlösliche Polythiophene der allgemeinen Formel II 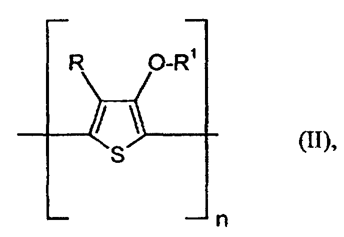 in der
- n: für eine ganze Zahl von 5 bis 100,
- R: für H oder eine Alkylgruppe mit 1 bis 12 C-Atomen,
- R¹: für -(CH₂)ₘ-SO₃M mit M=Li, Na, K, Rb, Cs, NH₄, H und
- m: für eine ganze Zahl von 1 bis 12
steht.

Die Herstellung dieser Polythiophene ist in der WO-A 98/03499 beschrieben.

Die Polythiophene der Formeln I und II können allein oder als Mischung eingesetzt werden.

Besonders bevorzugt sind leitfähige Polymere der Formel I in Kombination mit Polyanionen, wie beispielsweise in EP-A 440 957 beschrieben. Besonders geeignete Lösungen oder Dispersionen von leitfähigen Polymeren werden erhalten, wenn, bezogen auf ein Gewichtsteil Polyanion, weniger als 0,4, insbesondere weniger als 0,3 Gewichtsteile des leitfähigen Polymers der Formel I zugegen sind.

Dieses Verhältnis von leitfähigem Polymer zu Polyanion kann direkt bei der Herstellung eingestellt werden. Es hat sich aber gezeigt, daß es auch möglich ist, von einer Lösung oder Dispersion mit einem höheren Anteil an leitfähigem Polymer auszugehen und erst anschließend das erfindungsgemäße Verhältnis von leitfähigem Polymer zu Polyanion durch Zugabe von Salzen der Polyanionen oder freien Säuren der Polyanionen einzustellen.

Diese bevorzugt einzusetzenden Lösungen oder Dispersionen haben außerdem den Vorteil, daß die Leitfähigkeit der Schicht im Vergleich zu einer Lösung oder Dispersion mit einem Polythiophen der Formel I zu Polyanion-Verhältnis von 0,4 zu 1 reduziert wird. Hierdurch wird der sogenannte Cross Talk (Braun in Synth. Metals, 92 (1998) 107-113) in elektrolumineszierenden Matrixdisplays reduziert. Bevorzugt werden daher Lösungen oder Dispersionen eingesetzt, die zu Schichten mit einem Oberflächenwiderstand von >10⁵ Ω/□ bei einer Trockenfilmdicke von 75 nm führen bzw. Schichten mit einer Leitfähigkeit <2 S/cm.

Die Herstellung der erfindungsgmäßen elektrolumineszierenden Anordnung erfolgt nach grundsätzlich bekannten Technologien. Zur Herstellung der Zwischenschichten 3 wird bei den erfindungsgemäßen Systemen eine Lösung oder Dispersion des Polythiophens auf der Basiselektrode als Film verteilt. Als Lösungsmittel werden bevorzugt Wasser bzw. Wasser/Alkohol-Gemische verwendet. Geeignete Alkohole sind beispielsweise Methanol, Ethanol, Propanol, Isopropanol, Butanol. Die Verwendung dieser Lösungsmittel hat den Vorteil, daß dann weitere Schichten aus organischen Lösungsmitteln, wie aromatischen oder aliphatischen Kohlenwasserstoffgemischen aufgebracht werden können, ohne daß die Schicht 3 angegriffen wird.

Vorzugsweise werden die Lösungen oder Dispersionen der polymeren organischen Leiter vor der Beschichtung durch einen Filter, beispielsweise einen Membranfilter der Fa. Millipore, mit einer Porengröße von <0,5 µm filtriert. Besonders bevorzugt werden Filter <0,25 µm verwendet.

Den Lösungen oder Dispersionen der polymeren organischen Leiter können außerdem organische, polymere Bindemittel und/oder organische, niedermolekulare Vernetzungsmittel zugesetzt werden. Entsprechende Bindemittel sind beispielsweise in der EP-A 564 911 beschrieben.

Bevorzugt werden Lösungen oder Dispersionen der polymeren organischen Leiter verwendet, die weniger als 10 ppm Metallionen und/oder weniger als 10 ppm Anionen anorganischer Säuren enthalten. Besonders bevorzugt werden Lösungen oder Dispersionen der polymeren organischen Leiter verwendet, die weniger als 1 ppm Metallionen und/oder weniger als 1 ppm Anionen anorganischer Säuren enthalten.

Die Lösung oder Dispersion des polymeren organischen Leiters wird durch Techniken wie Spincoaten, Casting, Rakeln, Drucken, Vorhanggießen auf dem Substrat gleichmäßig verteilt. Anschließend werden die Schichten bei Raumtemperatur oder Temperaturen bis 300°C, bevorzugt bis 200°C, getrocknet.

Die Lösung oder Dispersion kann bevorzugt durch Druck-Techniken wie Ink-Jet auch strukturiert aufgebracht werden. Diese Technik ist für wasserlösliche Polythiophene, beispielsweise in Science, Vol. 279, (1998), beschrieben.

Es hat sich gezeigt, daß bei Verwendung von vollflächig mit Indium-Zinnoxid beschichteten Trägern, auf die die leitfähige Polymerschicht strukturiert aufgebracht wurde, die anschließend ebenfalls vollflächig aufgetragene Emitterschicht nur an den Stellen Licht emittiert, die mit leitfähigem Polymer beschichtet sind. Nach diesem Verfahren ist es auf einfache Weise ohne Strukturierung der leitfähigen Basiselektrode möglich, strukturierte Elektrolumineszensanzeigen herzustellen.

Die Dicke der erfindungsgemäßen Zwischenschicht 3 beträgt etwa 3 bis 500 nm, vorzugsweise 10 bis 200 nm.

Auf die erfindungsgemäß hergestellte Zwischenschicht 3 werden anschließend die weiteren Schichten durch Abscheiden aus Lösung oder durch Aufdampfen aufgebracht. Bevorzugt werden hierbei als Emitterschicht 5 Polyparaphenylenvinylenderivate oder Aluminiumkomplexe wie Aluminiumchinolat verwendet. Bei Einsatz von Polyparaphenylenvinylenderivaten kann die zusätzliche lochinjizierende Schicht 4 vorzugsweise entfallen.

Die erfindungsgemäß hergestellten Elektrolumineszensanzeigen zeichnen sich durch hohe Lebensdauer, Leuchtstärke und niedrige Einsatzspannungen aus.

### Beispiele

### Vergleichsbeispiel:

### Filtrations Versuch von Baytron® P (3,4-Polyethylendioxythiophen/Polystyrolsulfonat-Dispersion, PEDT/PSS 1:2,5 (Bayer AG)

Die Baytron® P-Dispersion konnte nicht durch einen 0,45 µm Membran-Filter der Fa. Millipore filtriert werden. Die Dispersion wurde deshalb ohne Filtration zur Herstellung elektrolumineszierender Anzeigen eingesetzt.

### Beispiel 1

### Herstellung der 3,4-Polyethylendioxythiophen/Polystyrolsulfonat-Dispersion, PEDT/PSS 1:4

20 g freie Polystyrolsulfonsäure (Mn ca. 40.000), 13,4 g Kaliumperoxodisulfat und 50 mg Eisen(III)-sulfat werden unter Rühren in 2000 ml Wasser vorgelegt. Unter Rühren werden 5,0 g 3,4-Ethylendioxythiophen zugegeben. Die Dispersion wird 24 h bei Raumtemperatur gerührt. Anschließend werden 100 g Anionenaustauscher Lewatit® MP 62 (Bayer AG) und 100 g Kationenaustauscher Lewatit® S 100 (Bayer AG), beide wasserfeucht, zugegeben und 8 Stunden gerührt.

Die Ionenaustauscher werden durch Filtration über ein Polyacrylnitrilgewebe mit 50 µm Porengröße entfernt. Es wird eine Dispersion mit einem Feststoffgehalt von ca. 1,2 Gew.-% erhalten, die gebrauchsfertig ist.

Die Dispersion ließ sich leicht durch einen 0,45 µm Filter filtrieren. Die filtrierte Dispersion wurde zur Herstellung elektrolumineszierender Anzeigen eingesetzt.

### Beispiel 2

### Herstellung der 3,4-Polyethylendioxythiophen/Polystyrolsulfonat-Dispersion, PEDT/PSS 1:8

20 g freie Polystyrolsulfonsäure (Mn ca. 40.000), 6,7 g Kaliumperoxodisulfat und 50 mg Eisen(III)-sulfat werden unter Rühren in 2000 ml Wasser vorgelegt. Unter Rühren werden 2,5 g 3,4-Ethylendioxythiophen zugegeben. Die Dispersion wird 24 h bei Raumtemperatur gerührt. Anschließend werden 100 g Anionenaustauscher Lewatit® MP 62 (Bayer AG) und 100 g Kationenaustauscher Lewatit® S 100 (Bayer AG), beide wasserfeucht, zugegeben und 8 Stunden gerührt.

Die Ionenaustauscher werden durch Filtration über ein Polyacrylnitrilgewebe mit 50 µm Porengröße entfernt. Es wird eine Dispersion mit einem Feststoffgehalt von ca. 1,1 Gew.-% erhalten, die gebrauchsfertig ist.

Die Dispersion konnte leicht durch ein 0,22 µm Filter filtriert werden. Die filtrierte Dispersion wurde zur Herstellung elektrolumineszierender Anzeigen eingesetzt.

### Anwendungsbeispiele

### Vergleichsbeispiel 1

Beim erfindungsgemäßen Aufbau einer organischen Leuchtdiode (OLED) wird folgendermaßen vorgegangen:
1. Reinigung des ITO-Substrats
   ITO-beschichtetes Glas (Merck Balzers AG, Part.No.253 674 XO) wird in 50 mm x 50 mm-große Stücke (Substrate) geschnitten. Die Substrate werden anschließend in 3 %iger wäßriger ®Mukasol-Lösungen im Ultraschalbad 15 min lang gereinigt. Danach werden die Substrate mit destilliertem Wasser gespült und in einer Zentrifuge trocken geschleudert. Dieser Spül- und Trockenvorgang wird 10 mal wiederholt.
2. Aufbringen der Baytron P -Schicht auf das ITO
   Das Substrat wird auf eine Lacksehleuder gelegt und etwa 10 ml der 1,3 %igen Polyethylendioxythiophen/Polystyrolsulfonsäure-Lösung (Baytron P) werden auf der ITO-beschichteten Seite des Substrats verteilt. Anschließend wird die überstehende Lösung durch Rotation des Tellers bei 500 U/min über den Zeitraum von 3 min abgeschleudert. Danach wird das so beschichtete Substrat 5 min lang bei 110°C auf einer Heizplatte getrocknet. Die Schichtdicke beträgt 60 nm (Tencor, Alphastep 200) ist allerdings inhomogen und enthält Stippen.
3. Aufbringen der lochleitenden Schicht
   5 ml einer 1,5 %igen Dichlorethanlösung aus 1 Gew.-Teil Polyvinylcarbazol (BASF ®Luvican) und 2 Gew.-Teilen Amin A (Formel III) werden filtriert (Millipore® HV, 0,45 µm) und auf der getrockneten Baytron P Schicht verteilt. Anschließend wird die überstehende Lösung durch Rotation des Tellers bei 800 U/min 60 sec lang abgeschleudert. Danach wird das so beschichtete Substrat 5 min lang bei 110°C auf einer Heizplatte getrocknet. Die Gesamtschichtdicke beträgt 150 nm. 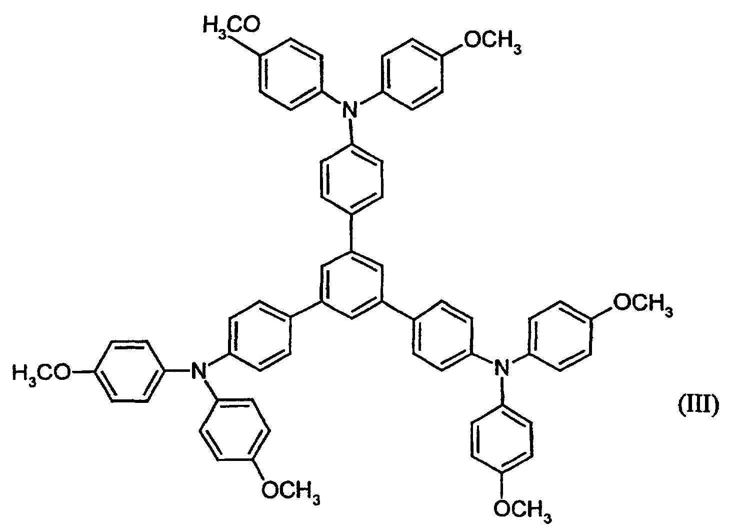
4. Aufdampfen der lichtemittierenden/elektroneninjizierenden Schicht
   Auf die so hergestellten zwei organischen Schichten wird eine dritte organische Schicht, nämlich die erfindungsgemäße Substanz Aluminium-trishydroxychinolat, thermisch gedampft. Dies wird in einer Aufdampfanlage (Leybold, Univex350) durchgeführt. Der Druck in der Aufdampfanlage beträgt während des Aufdampfens 10⁻³ Pa und die Aufdampfrate beträgt 2 Å/sec. Die Gesamtschichtdicke der 3 organischen Schichten beträgt 200 nm.
5. Aufdampfen der Metallkathode
   Auf das organische Schichtsystem wird eine Metallelektrode gedampft. Dazu wird das Substrat mit dem organischen Schichtsystem nach unten auf eine Lochmaske (Lochdurchmesser 5 mm) gelegt. Aus zwei Aufdampfschiffchen werden bei einem Druck von 10⁻³ Pa parallel die Elemente Mg und Ag verdampft. Die Aufdampfraten betragen für Mg: 28 Å/sec und für Ag: 2 Å/sec. Die Dicke der aufgedampften Metallkontakte beträgt 500 nm.

Die beiden Elektroden der organischen LED werden über elektrische Zuführungen mit einer Spannungsquelle verbunden. Der positive Pol ist mit der ITO-Elektrode, der negative Pol ist mit der MgAg-Elektrode verbunden.

Beim Anlegen einer Spannung kommt es zu Kurzschlüssen, so daß sich kein zeitlich stabiler Stromfluß und keine zeitlich stabile Elektrolumineszenz einstellt.

### Vergleichsbeispiel 2

Vorgehen beim erfindungsgemäßen Aufbau einer OLED wie in Beispiel 1, mit dem Unterschied, daß anstelle von Baytron P, eine unfiltrierte Polyethylendioxythiophendispersion aus Beispiel 2 aufgeschleudert wird. Dazu wird folgendermaßen vorgegangen:

Das Substrat wird auf eine Lackschleuder gelegt und etwa 10 ml der Polyethylendioxythiophen/Polysulphonsäure-Lösung werden auf der ITO-beschichteten Seite des Substrats verteilt. Anschließend wird die überstehende Lösung durch Rotation des Tellers bei 500 U/min über den Zeitraum von 3 min abgeschleudert. Danach wird das so beschichtete Substrat 5 min lang bei 110°C auf einer Heizplatte getrocknet. Die Schichtdicke beträgt 60 nm (Tencor, Alphastep 200) ist allerdings inhomogen und enthält Stippen.

Beim Anlegen einer Spannung kommt es zu Kurzschlüssen, so daß sich kein zeitlich stabiler Stromfluss und keine zeitlich stabile Elektrolumineszenz einstellt.

### Anwendungsbeispiel 1

Vorgehen beim erfindungsgemäßen Aufbau einer OLED wie in Beispiel 1, mit dem Unterschied, daß eine durch ein 0,45 µm Filter filtrierte Lösung aus Beispiel 1 aufgeschleudert wird. Dazu wird folgendermaßen vorgegangen:

Das Substrat wird eine Lackschleuder gelegt und die filtrierte Lösung aus Beispiel 1 wird auf der ITO-beschichteten Seite des Substrats verteilt. Anschließend wird die überstehende Lösung durch Rotation des Tellers bei 500 U/min über den Zeitraum von 3 min abgeschleudert. Danach wird das so beschichtete Substrat 5 min lang bei 110°C auf einer Heizplatte getrocknet. Die Schichtdicke beträgt 60 nm (Tencor, Alphastep 200) ist homogen und enthält keine Stippen.

Bereits ab einer Spannung von 3 Volt läßt sich mit einer Photodiode (EG&G C30809E) Elektrolumineszenz nachweisen. Bei einer Spannung von 10 Volt fließt ein zeitlich stabiler Flächenstrom von 100 mA/cm² und die zeitlich stabile Elektrolumineszenz-Intensität beträgt 2500 cd/m². Die Farbe der Elektrolumineszenz ist grünblau.

## Patentansprüche

1. Elektrolumineszierende Anordnung, die als lochinjizierende Schicht einen polymeren organischen Leiter enthält, der aus einer Dispersion aufgebracht worden ist, in der die Teilchen eine Größe unterhalb von 0,5 µm aufweisen, wobei als lochinjizierende Schicht ein polymerer organischer Leiter aus gegebenenfalls substituierten neutralen oder kationischen 3,4-Polyalkylendioxy-thiophenen der Formel I 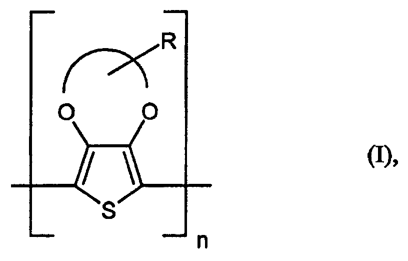 in der
n für eine ganze Zahl von 5 bis 100 und
R für H, einen gegebenenfalls substituierten Alkylrest mit 1 bis 20 C-Atomen, -CH₂-OH oder einen Arylrest mit 6 - 14 C-Atomen
steht, oder
aus gegebenenfalls substituierten neutralen oder kationischen Polyalkoxythiophenen der Formel II 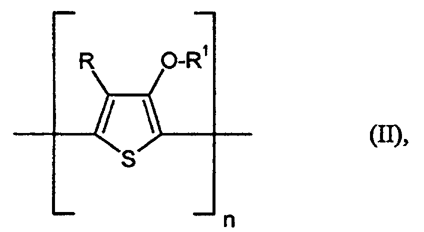 in der
n für eine ganze Zahl von 5 bis 100,
R für H oder eine Alkylgruppe mit 1 bis 12 C-Atomen,
R¹ für -(CH₂)ₘ-SO₃M mit M=Li, Na, K, Rb, Cs, NH₄, H und
m für eine ganze Zahl von 1 bis 12
steht, enthalten ist.

2. Elektrolumineszierende Anordnung nach Anspruch 1, **dadurch gekennzeichnet, dass** die lochinjizierende Schicht aus Dispersion aufgebracht worden ist und die Teilchen der Dispersion eine Größe unterhalb von <0,25 µm aufweisen.

3. Elektrolumineszierende Anordnung nach Anspruch 1, **dadurch gekennzeichnet, dass** der Oberflächenwiderstand einer 75 nm dicken lochinjizierenden Schicht >10⁵ Ω/□ beträgt.

4. Elektrolumineszierende Anordnung nach Anspruch 1, **dadurch gekennzeichnet, dass** die Leitfähigkeit der lochinjizierenden Schicht < 2 S/cm beträgt.

5. Elektrolumineszierende Anordnung nach Anspruch 1, **dadurch gekennzeichnet, dass** in der lochinjizierenden Schicht auf weniger als 0,4 Gewichtsteile des leitfähigen Polythiophens der Formel I ein Gewichtsteil Polyanion enthalten ist.

## Claims

1. Electroluminescent assembly containing, as hole injection layer, a polymeric organic conductor which has been applied from a dispersion in which the particles have a size of less than 0.5 µm, wherein the hole injection layer present is a polymeric organic conductor comprising substituted or unsubstituted, uncharged or cationic 3,4-polyalkylenedioxy-thiophenes of the formula I 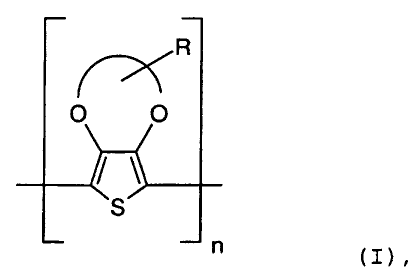 where
n represents an integer from 5 to 100 and
R represents H, a substituted or unsubstituted alkyl radical having from 1 to 20 carbon atoms, -CH₂-OH or an aryl radical having 6 - 14 carbon atoms,
or
comprising substituted or unsubstituted, uncharged or cationic polyalkoxythiophenes of the formula II 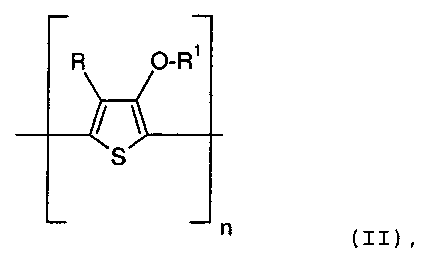 where
n represents an integer from 5 to 100,
R represents H or an alkyl group having from 1 to 12 carbon atoms,
R¹ represents -(CH₂)ₘ-SO₃M where M=Li, Na, K, Rb, Cs, NH₄, H and
m represents an integer from 1 to 12.

2. Electroluminescent assembly according to Claim 1, **characterized in that** the hole injection layer has been applied from a dispersion and the particles of the dispersion have a size of <0.25 µm.

3. Electroluminescent assembly according to Claim 1, **characterized in that** the surface resistance of a 75 nm thick hole injection layer is >10⁵ Ω/□.

4. Electroluminescent assembly according to Claim 1, **characterized in that** the conductivity of the hole injection layer is < 2 S/cm.

5. Electroluminescent assembly according to Claim 1, **characterized in that**, in the hole injection layer, one part by weight of polyanion is present per <0.4 part by weight of the conductive polythiophene of the formula I.

## Revendications

1. Agencement électroluminescent qui contient comme couche injectant des trous un conducteur organique polymère qui est appliqué à partir d'une dispersion, dans laquelle les particules présentent une grosseur inférieure à 0,5 µm, dans lequel est contenu comme couche injectant des trous un conducteur organique polymère constitué de 3,4-polyalkylènedioxythiophène neutre ou cationique le cas échéant substitué de formule I 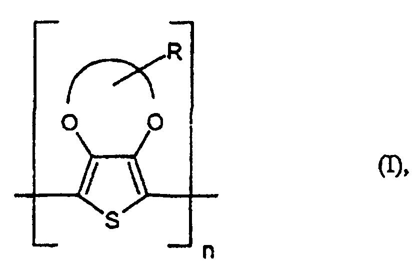 dans laquelle
n est un nombre entier de 5 à 100 et
R est H, un radical alkyle le cas échéant substitué avec 1 à 20 atomes de carbone, -CH₂-OH ou un radical aryle avec 6 à 14 atomes de carbone
ou
de polyalcoxythiophène neutre ou cationique le cas échéant substitué de formule II 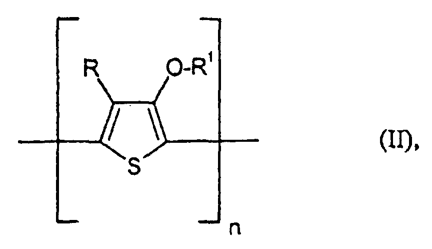 dans laquelle
n est un nombre entier de 5 à 100,
R est H ou un groupement alkyle avec 1 à 12 atomes de carbone,
R¹ signifie -(CH₂)ₘ-SO₃M, avec M=Li, Na, K, Rb, Cs, NH₄, H et
m est un nombre entier de 1 à 12

2. Agencement électroluminescent selon la revendication 1, **caractérisé en ce que** la couche injectant destrous est appliquée à partir d'une dispersion et les particules de la dispersion présentent une grosseur inférieure à < 0,25 µm.

3. Agencement électroluminescent selon la revendication 1, **caractérisé en ce que** la résistance superficielle d'une couche injectant des trous épaisse de 75 nm s'élève à > 10⁵ Ω/□.

4. Agencement électroluminescent selon la revendication 1, **caractérisé en ce que** la conductivité de la couche initiatrice de trous est < 2 S/cm.

5. Agencement électroluminescent selon la revendication 1, **caractérisé en ce que**, sur moins de 0,4 partie en poids du polythiophène conducteur de formule I, la couche injectant des trous contient une partie en poids de polyanion.
